Europäisches Patentamt

European Patent Office

Office européen des brevets

(19)

(11) **EP 0 548 495 B1**

(12) **EUROPÄISCHE PATENTSCHRIFT**

(45) Veröffentlichungstag und Bekanntmachung des Hinweises auf die Patenterteilung:
**06.08.1997 Patentblatt 1997/32**

(51) Int Cl.$^6$: **G01R 27/26**, G01D 5/20

(21) Anmeldenummer: **92118050.1**

(22) Anmeldetag: **22.10.1992**

(54) **Verfahren und Schaltungsanordnung zur Messung der Induktivität einer Spule**

Procedure and circuit for measuring inductance of a coil

Procédé et circuit pour mesurer l'inductance d'une bobine

(84) Benannte Vertragsstaaten:
**DE FR GB SE**

(30) Priorität: **13.12.1991 DE 4141065**

(43) Veröffentlichungstag der Anmeldung:
**30.06.1993 Patentblatt 1993/26**

(73) Patentinhaber: **VDO Adolf Schindling AG**
**D-60487 Frankfurt (DE)**

(72) Erfinder:
- **Berberich, Reinhold**
  **W-6000 Frankfurt 50 (DE)**
- **Schmid, Dietmar**
  **W-6256 Villmar (DE)**

(74) Vertreter: **Klein, Thomas, Dipl.-Ing. (FH)**
**Sodener Strasse 9**
**65824 Schwalbach/Ts. (DE)**

(56) Entgegenhaltungen:
**EP-A- 0 289 711      DE-A- 2 852 637**

**Beschreibung**

Die Erfindung betrifft ein Verfahren zur Messung der Induktivität einer Spule, gemäß dem Oberbegriff des Patentanspruchs 1 sowie Schaltungsanordnungen zur Durchführung des Verfahrens.

Insbesondere zur Messung von Wegen in Kraftfahrzeugen, Maschinen und Anlagen haben sich induktive Sensoren bewährt, bei welchen die Veränderung der Induktivität einer Spule als Funktion des zu messenden Weges ausgewertet wird. Zur Messung der Induktivität ist es beispielsweise aus DE 35 19 978 A1 bekannt, die Spule während einer Messung über eine Strombegrenzung und einen Schalter an eine Spannungsquelle anzuschließen. Dabei wird die Zeit vom Anlegen einer Meßspannung bis zum Einsatz der Strombegrenzung durch einen Mikrocomputer ausgewertet und in die vom Sensor erfaßte Größe umgerechnet.

Bei einer anderen bekannten Schaltung nach DE 38 07 015 A1 wird die Spule mit einem konstanten geregelten Strom beaufschlagt, der Strom abgeschaltet, die in der Induktivität induzierte Abschaltspannung auf einen vorgegebenen Wert begrenzt und die Abklingzeit des durch die Induktivität fließenden Stroms gemessen. Diese bekannten Schaltungsanordnungen haben den Nachteil, daß mehrere verfälschende Einflüsse auf das Meßergebnis einwirken. Zusätzlich zu Ungenauigkeiten der Stromquelle unterliegt der vorgegebene Spannungswert Veränderungen und Streuungen. Außerdem ist ein erheblicher Aufwand u Realisierung der Stromquelle erforderlich.

Eine gattungsgemäße Auswerteschaltung für Induktivgeber ist aus der DE 28 52 637 A1 bekannt. Bei dieser Anordnung wird der Spule direkt über einen Transistor eine von einem Oszillator erzeugte Spannung zugeführt. Unterschreitet der Spannungsabfall an einem Meßwiderstand einen an einem Eingang eines Komparators eingestellten Spannungswert, schaltet der Komparator um. Die Zeit zwischen dem Schalten des Oszillators und dem Schalten des Komparators ist dabei proportional zur Induktivität der Spule. Das Meßergebnis wird aber durch Schaltverzögerungen der Elektronik verfälscht.

Auch aus der EP-A-0 289 711 ist eine Auswerteschaltung für einen induktiven Sensor bekannt. Die zu messende Induktivität ist Bestandteil einer Wheatstoneschen Brücke. Der Induktivität ist ein Schalter zugeordnet. Die Brückenspannung wird durch einen Komparator überwacht. Ein Mikrocomputer erfaßt die Zeit zwischen der Betätigung des Schalters und dem Nulldurchgang der Brückenschaltung, welche dem Wert der Induktivität proportional ist.

Aufgabe der vorliegenden Erfindung ist es, ein Verfahren und Schaltungsanordnungen zur Messung der Induktivität einer Spule mit einer hohen Meßgenauigkeit anzugeben, die mit einfachen Mitteln unter Betriebsbedingungen durchgeführt werden können.

Das erfindungsgemäße Verfahren ist durch die Merkmale des kennzeichers des Patentanspruchs 1 gekennzeichnet.

Durch die Messung der Induktivität über die Aufladezeit bei dem erfindungsgemäßen Verfahren ist es möglich, temperaturbedingte Änderungen der Induktivität mit temperaturabhängigen Widerständen zu kompensieren. Das erfindungsgemäße Verfahren hat ferner den Vorteil, daß beide Flanken in die Auswertung eingehen, so daß sich die entsprechenden Schaltverzögerungen weitgehend aufheben. Das Verfahren kann mit einfachen Schaltungsanordnungen durchgeführt werden. Ein bevorzugtes Anwendungsgebiet des erfindungsgemäßen Verfahrens sind Sensoren zur Fahrwerksregelung in Kraftfahrzeugen.

Eine Weiterbildung des erfindungsgemäßen Verfahrens besteht darin, daß die Spule während einer Dauer mit der Spannung beaufschlagt ist, welche größer als die Zeit ist, die zwischen dem Beginn der Beaufschlagung und dem Zeitpunkt ist, zu dem der Spannungsabfall die Vergleichsspannung überschreitet. Hierbei kann auf einen Fehler geschlossen werden, wenn die Dauer des ersten Pegels diejenige durch den entsprechenden Grenzwert der Messung vorgegebene Zeit überschreitet.

Eine andere Weiterbildung besteht darin, daß zur Messung der Induktivitäten mehrerer Spulen die Beaufschlagung der Spulen mit der Spannung über je einen Meßwiderstand gleichzeitig erfolgt und daß die Ausgangssignale getrennt einer Auswerteeinrichtung zugeführt werden. Bei dieser Weiterbildung können mehrere Sensoren mit gleichen Taktsignalen versehen werden, während die Ausgangssignale unabhängig voneinander ausgewertet werden.

Bei einer anderen Weiterbildung des erfindungsgemäßen Verfahrens zur Messung der Induktivitäten mehrerer Spulen ist vorgesehen, daß die Beaufschlagung der Spulen mit der Spannung zeitlich versetzt erfolgt und daß die Ausgangssignale nach einer logischen Verknüpfung gemeinsam einer Auswerteeinrichtung zugeführt werden. Hierbei sind zwar für die Versorgung der Sensoren mit einem Taktsignal mehrere Leitungen erforderlich. Es entsteht jedoch ein gemeinsamer Meßausgang, der nacheinander die Meßwerte aller Sensoren führt.

Dieses hat einerseits den Vorteil, daß bei einer nachgeschalteten Auswerteschaltung, beispielsweise einem Mikrocomputer, nur ein Eingang zur Auswertung der Ausgangssignale aller Meßschaltungen erforderlich ist. Dieser kann beispielsweise ein Port mit einem Capture-Register sein. Andererseits hat diese Weiterbildung den Vorteil, daß während der Entladezeit für die Induktivität in einem Sensor, während der an sich abgewartet werden muß, bis eine erneute Messung erfolgen kann, die anderen Sensoren bzw. Meßschaltungen abgefragt werden können. Dieses führt zu einer zeitlichen Entzerrung der Auswertung der Ausgangssignale mehrerer Meßschaltungen in der nachgeschalteten Auswerteschaltung, wodurch die Meßschaltungen nacheinander ohne gegenseitige Überschneidung abgefragt werden können.

Eine andere Weiterbildung des erfindungsgemäßen Verfahrens besteht darin, daß die an der Spule im eingeschwungenen Zustand abfallende Spannung gemessen und zur Korrektur einer vom Ausgangssignal abgeleiteten Größe verwendet wird. Hierdurch ist ohne zusätzlichen Schaltungsaufwand eine Messung der Temperatur des Sensors möglich, die in der Auswerteschaltung zu einer Kompensation von zeitlichen Änderungen der Temperatur des Sensors genutzt werden kann. Dadurch, daß die Temperatur mit Hilfe des Widerstandes $R_L$ der Spule gemessen wird, ist kein zusätzlicher Temperatursensor oder anderer Schaltungsaufwand erforderlich. Es tritt auch kein zeitlicher Versatz zwischen Temperaturänderungen des Sensors und einem separaten Temperatursensor bzw. einem zusätzlichen temperaturabhängigen Widerstand auf.

Eine erste Schaltungsanordnung zur Durchführung des erfindungsgemäßen Verfahrens ist durch die Merkmale des Kennzeichens des Anspruchs 6 charakterisiert.

Mit dieser Schaltungsanordnung ist eine hohe Meßgenauigkeit erzielbar, obwohl keinerlei besondere Anforderungen an die zugeführte Spannung gestellt werden, also auch keine Stabilisierung dieser Spannung erforderlich ist. Die Frequenz des Ansteuertaktes geht ebenfalls nicht in das Meßergebnis ein. Außerdem wirkt eine Schaltverzögerung (Response Time) des Komparators auf beide Flanken, so daß nur die Differenz der Schaltverzögerungen in beiden Richtungen in die Messung eingeht. Eine durch den steuerbaren Schalter bedingte Verzögerungszeit geht nicht in das Meßergebnis ein, da ausschließlich die Spannung an der Spule gemessen wird.

Eine Weiterbildung der erfindungsgemäßen Schaltungsanordnung besteht darin, daß der Spannungsteiler an die Spannung über einen mit dem steuerbaren Schalter gleichartigen weiteren Schalter angeschlossen ist. Hierdurch wird auch ein Temperaturgang der Durchlaßspannung des steuerbaren Schalters kompensiert.

Zur Messung der Temperatur der Spule zu Kompensationszwecken ist eine zweite Schaltungsanordnung durch die Merkmale des Kennzeichens des Patentanspruchs 8 charakterisiert.

Die Erfindung läßt zahlreiche Ausführungsformen zu. Drei davon sind schematisch in der Zeichnung anhand mehrerer Figuren dargestellt und nachfolgend beschrieben. Es zeigt:

Fig. 1 ein Ausführungsbeispiel einer Schaltungsanordnung zur Durchführung des erfindungsgemäßen Verfahrens,

Fig. 2 Zeitdiagramme der bei der Schaltungsanordnung nach Fig. 1 auftretenden Spannungen,

Fig. 3 Zeitdiagramme des Ausgangssignals bei normalem Betrieb und bei verschiedenen Fehlern,

Fig. 4 ein Ausführungsbeispiel einer Schaltungsanordnung zur Messung der Induktivitäten mehrerer Spulen,

Fig. 5 Zeitdiagramme von bei der Schaltungsanordnung nach Fig. 4 auftretenden Signalen,

Fig. 6 ein weiteres Ausführungsbeispiel einer Schaltungsanordnung zur Durchführung des erfindungsgemäßen Verfahrens,

Fig. 7 Zeitdiagramme von Spannungen, die bei der Schaltungsanordnung nach Fig. 6 auftreten,

Fig. 8 ein Flußdiagramm eines Programms für den Mikrocomputer, das zur Ermittlung der Spuleninduktivität dient,

Fig. 9 ein Flußdiagramm eines Programms, das den ermittelten Wert temperaturabhängig kompensiert, und

Fig. 10 ein Beispiel für eine Korrekturdatei.

Gleiche Teile sind in den Figuren mit gleichen Bezugszeichen versehen.

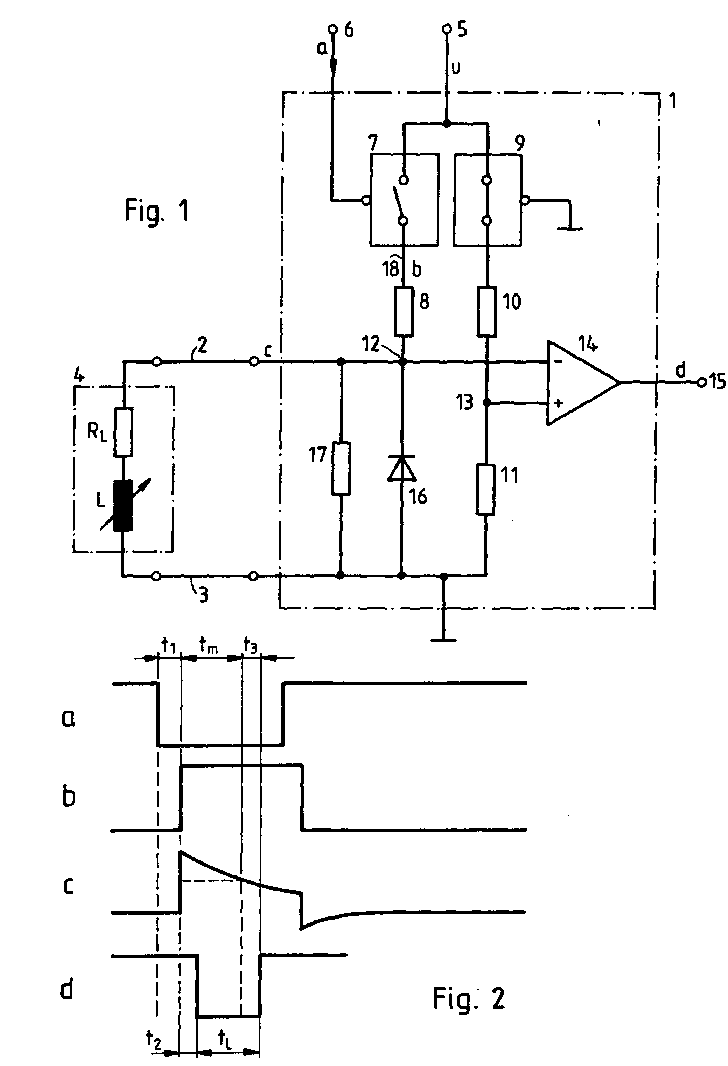

Fig. 1 stellt eine erfindungsgemäße Schaltungsanordnung 1 dar, die über Meßleitungen 2, 3 mit der Spule 4 eines Sensors verbunden ist. Außer einer als Funktion der zu messenden Größe veränderlichen Induktivität L weist die Spule einen ohmschen Wicklungs-Widerstand $R_L$ auf. Je nach Voraussetzungen im einzelnen können zur Kompensation des Temperaturverhaltens der Induktivität weitere in Fig. 1 nicht dargestellte Elemente, insbesondere temperaturabhängige Widerstände, vorgesehen sein. Über einen Anschluß 5 erhält die Schaltungsanordnung 1 eine Versorgungsspannung U.

Einem Eingang 6 wird ein rechteckförmiges Taktsignal zugeführt, das einen steuerbaren Schalter 7 derart steuert, daß der Schalter beim Pegel L des Taktsignals leitend ist. Damit wird die Reihenschaltung aus einem Meßwiderstand 8 und der Spule 4 mit der Spannung U beaufschlagt. Der steuerbare Schalter 7 kann von einem geeigneten Halbleiterschalter gebildet sein, beispielsweise einem PNP-Transistor. Ein weiterer Schalter 9 verbindet einen Spannungsteiler 10, 11 mit dem Anschluß 5. Der weitere Schalter ist ständig leitend und weist möglichst identische Eigenschaften mit dem Schalter 7 auf. Insbesondere ist der im leitenden Zustand verbleibende Spannungsabfall bei beiden Schaltern 7, 9 in gleicher Weise von der Temperatur abhängig.

Der Verbindungspunkt 12 zwischen dem Meßwiderstand 8 und der Spule 4 einerseits und der Ausgang 13 des Spannungsteilers 10, 11 andererseits sind mit Eingängen eines Komparators 14 verbunden. Das Ausgangssignal des Komparators 14 und damit das Signal am Ausgang 15 der Schaltungsanordnung 1 nehmen einen Pegel L an, solange der Spannungsabfall am Meßwiderstand 8 kleiner als der Spannungsabfall am Widerstand 10 ist. Vom Ausgang 15 kann das Ausgangssignal einer Auswerteschaltung, beispielsweise einem Mikrocomputer, zugeführt werden, der die jeweilige Dauer des Pegels L mißt und zu Steuerungs- bzw. Regelzwecken verwendet. Eine Diode 16 bewirkt eine Entladung der Induktivität nach dem Ende des Taktimpulses, ohne daß eine störende Spannungsspitze entsteht. Ein Widerstand 17 dient dazu, bei einer Unterbrechung der Meßleitungen 2, 3 und bei nichtleitendem Schalter 7 dem Schaltungspunkt 17 ein definiertes Potential zu geben.

Fig. 2 zeigt die Spannungen an den mit a bis d gleichlautend bezeichneten Punkten der Schaltungsanordnung nach Fig. 1. Zeile a zeigt einen Impuls des dem Eingang 6 zugeführten Taktsignals, während Zeile b die Spannung am Anschluß 18 des Schalters 7 (Fig. 1) darstellt. Das Einschalten ist gegenüber dem Taktsignal um eine Zeit $t_1$ verzögert. Gleichzeitig mit dem Anlegen der Spannung steigt auch die Spannung an dem Schaltungspunkt 12 plötzlich an und beginnt mit steigendem Strom durch die Spule um den Spannungsabfall am Meßwiderstand 8 zu sinken. Das in Zeile d dargestellte Ausgangssignal springt vom Wert H auf den Wert L erst nach einer weiteren Verzögerung (response time) $t_2$. Nach einer von der Induktivität L abhängigen Zeit $t_m$ ist die Spannung am Schaltungspunkt 12 auf die Spannung am Schaltungspunkt 13 gefallen, worauf das Ausgangssignal auf den Pegel H springt. Dieses erfolgt ebenfalls mit einer Verzögerung (response time) $t_3$, die jedoch im wesentlichen der Verzögerungszeit $t_2$ entspricht, so daß die Zeit $t_L$ recht genau ein Maß für die Induktivität darstellt.

Die Zeit $t_L$ ist nach folgender Funktion linear von der Induktivität abhängig:

$$t_L = [-\ln(0,6-0,4 \cdot R_L/R_8)/R_L+R_8] \cdot L,$$

wenn der Spannungsteiler aus den Widerständen 10, 11 die Spannung U im Verhältnis 0,4:0,6 aufteilt. $R_8$ ist der Wert des Meßwiderstandes 8. $R_{17}$ ist so hochohmig gewählt, daß er den Meßwiderstand nicht verfälscht.

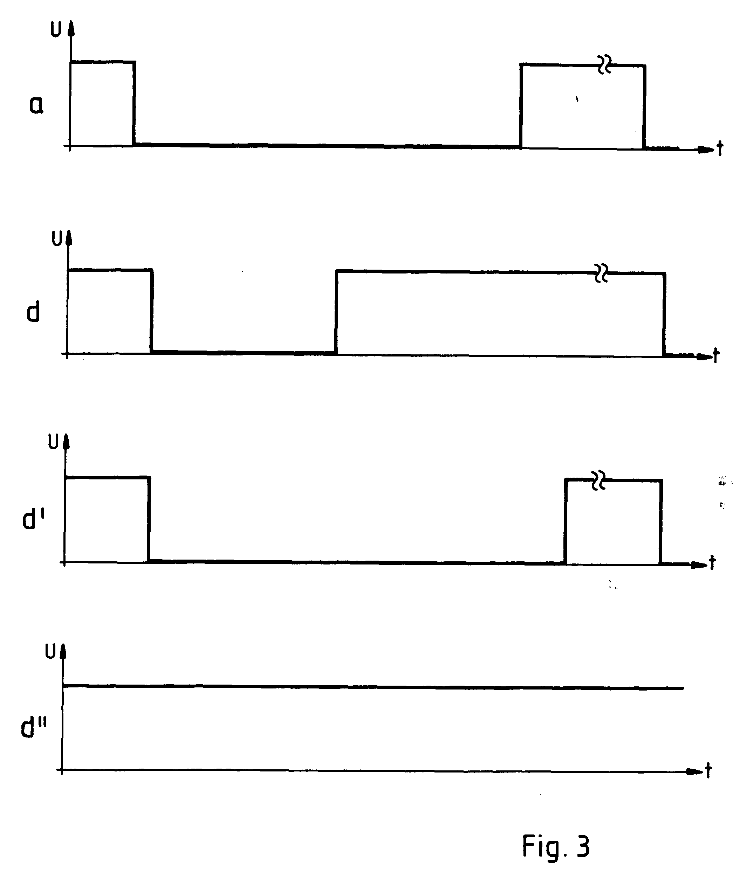

Fig. 3 zeigt das Taktsignal und das Ausgangssignal in den Zeilen a und d in einem gegenüber Fig. 2 vergrößerten Zeitmaßstab. Die Dauer des Pegels L bei dem Taktsignal ist größer gewählt, als die maximale Dauer des Pegels L beim Ausgangssignal. Zeile d' in Fig. 3 stellt das Ausgangssignal bei einer Unterbrechung der Meßleitungen 2, 3 dar. Dieses Ausgangssignal weist auch am Ende des L-Pegels des Taktsignals noch den Pegel L auf, so daß eine nachgeschaltete Auswerteschaltung hieran eine Unterbrechung der Meßleitungen erkennen kann.

Zeile d" der Fig. 3 zeigt das Ausgangssignal im Falle eines Kurzschlusses der Meßleitungen 2, 3, das dann ständig den Pegel H einnimmt. Auch hierdurch kann eine Auswerteschaltung auf den vorliegenden Fehler schließen.

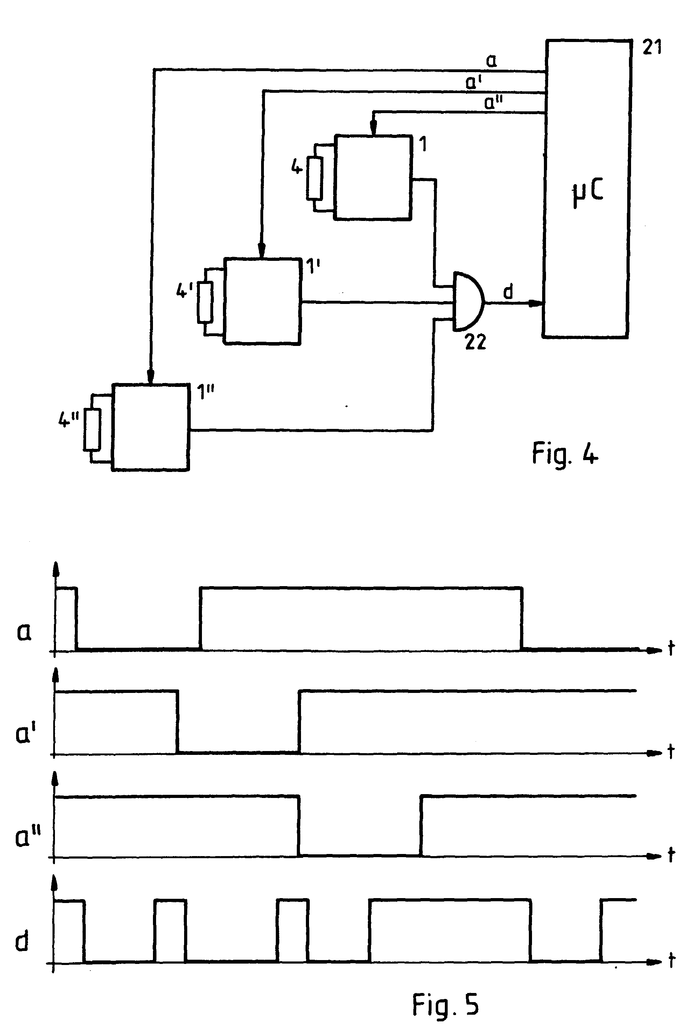

Fig. 4 zeigt eine Anordnung, bei welcher drei Schaltungsanordnungen (Meßschaltungen) 1, 1', 1", wie sie im Zusammenhang mit Fig. 1 beschrieben wurden, an je eine Spule 4, 4', 4" angeschlossen sind. Die Meßschaltungen werden gemeinsam mit einer Auswerteschaltung 21 betrieben, von der Taktsignale a, a', a" erzeugt und den Meßschaltungen 1, 1', 1" zugeführt werden. Die Ausgangssignale der Meßschaltungen werden über eine Und-Schaltung 22 einem Eingang der Auswerteschaltung 21 zugeführt.

Die weitere Erläuterung der Anordnung nach Fig. 4 wird anhand der Zeitdiagramme in Fig. 5 vorgenommen. Dabei stellen die Zeilen a, a' und a" die Taktsignale dar, die zeitlich gegeneinander versetzt sind. Dabei kann eine gewisse Überlappung erfolgen, solange der nicht überlappte Teil der einzelnen Impulse größer als die größte zu erwartende Meßzeit ist. Zeile d stellt das Ausgangssignal der Und-Schaltung 22 dar, bei welchem nacheinander die Zeiten $t_L$, $t_L'$ und $t_L"$ als Meßergebnisse auftreten. Da die Taktsignale von der gleichen Auswerteschaltung 21 erzeugt werden, die auch die Auswertung des Signals d vornimmt, ist eine Zuordnung der einzelnen Zeitabschnitte des Signals d zu der jeweiligen Meßschaltung ohne weiteres möglich.

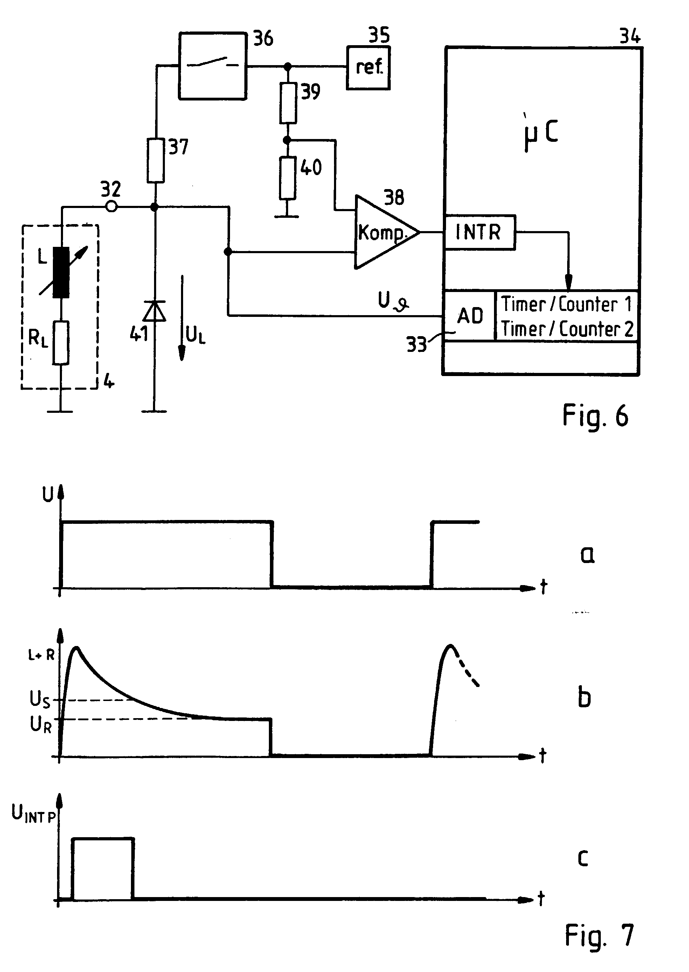

Bei der Schaltungsanordnung nach Fig. 6 ist die Spule 4 einerseits mit Massepotential und andererseits mit einem Eingang 32 verbunden. Der Eingang 32 ist mit dem Eingang eines Analog/Digital-Wandlers 33 verbunden, der Teil eines Mikrocomputers 34 ist. Außerdem ist eine Bezugsspannungsquelle 35 über einen steuerbaren Schalter 36 und einen Widerstand 37 mit dem Widerstandswert $R_S$ an den Eingang angeschlossen. Schließlich ist die Spannung $U_L$ am Eingang 32 einem ersten Eingang eines Komparators 38 zuführbar, dessen zweiter Eingang mit einem Teil $U_S$ der Bezugsspannung beaufschlagt ist, der durch einen Spannungsteiler 39, 40 festgelegt ist. Der Ausgang des Komparators 38 ist mit einem Interrupt-Eingang INTP des Mikrocomputers 34 verbunden. Eine Diode 41 zwischen dem Eingang 32 und Massepotential dient dazu, negative Spannungsspitzen beim Abschalten der Bezugsspannung zu unterdrücken und sorgt für das Entladen der Induktivität bis zur nächsten Messung.

Dem steuerbaren Schalter 36 wird eine rechteckförmige Steuerspannung zugeführt, die in Zeile a der Fig. 7 dargestellt ist. Die Steuerspannung kann vom Mikrocomputer 34 oder von einem unabhängigen Impulsgeber bereitgestellt werden. Die Impulsdauer Tp ist dabei mindestens so groß gewählt, daß während dieser Zeit der durch die Induktivität L bedingte Einschwingvorgang abgeschlossen ist, so daß der Spannungsabfall am Spulenwiderstand $R_L$ noch vor dem Ende des Impulses gemessen werden kann.

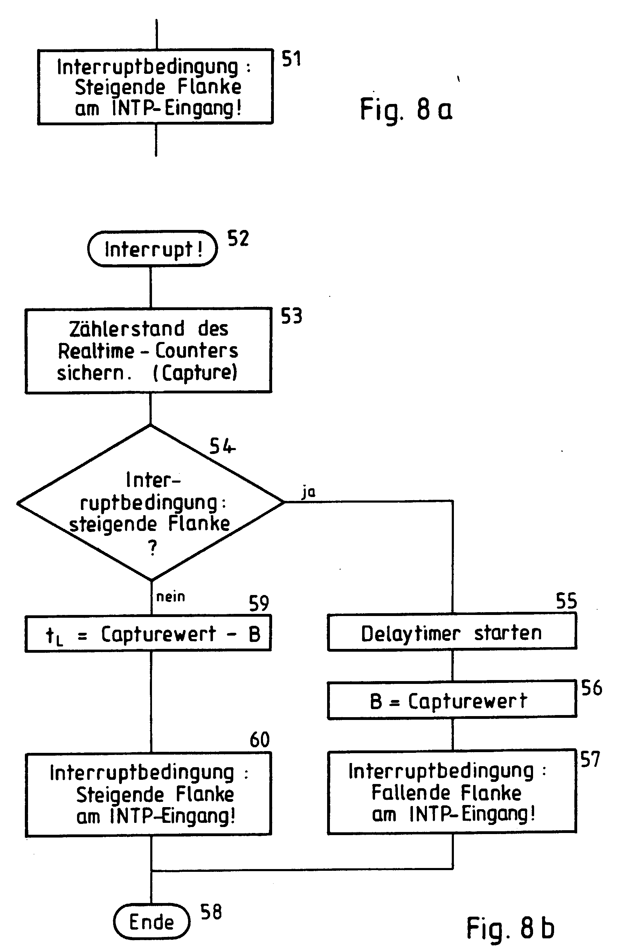

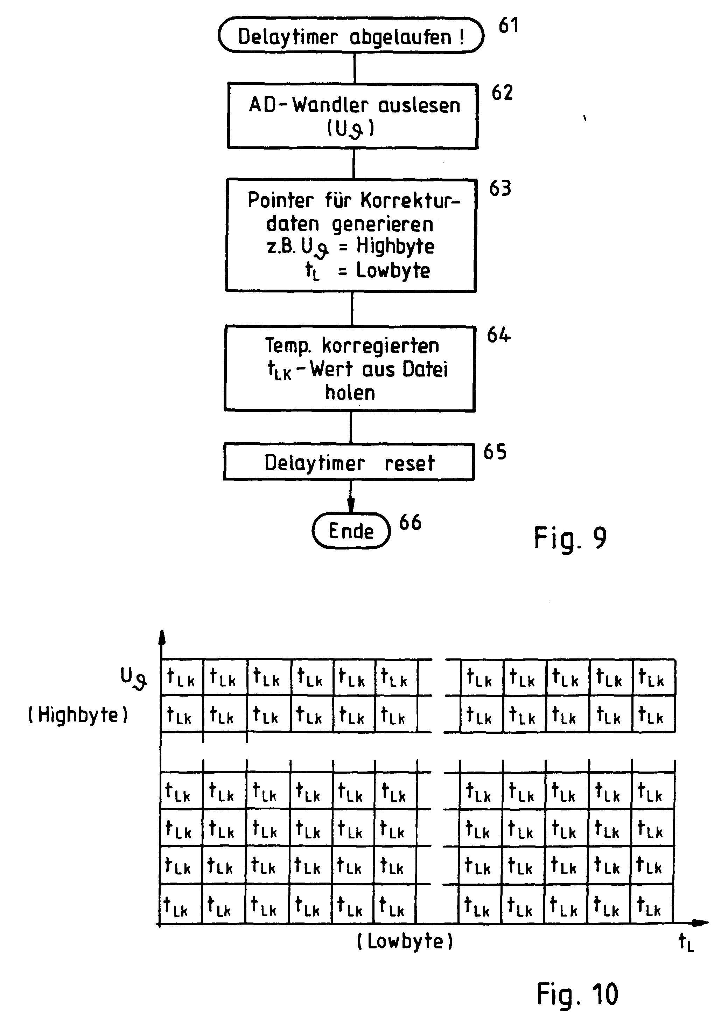

Zeile b der Fig. 7 zeigt die Spannung am Eingang 32 während der Dauer eines Impulses der Steuerspannung. Dabei ist die Spannungsüberhöhung zu Beginn des Impulses eine Folge des induktiven Verhaltens der Spule. Der Spannungsanstieg wird durch parasitäre Kapazitäten verschliffen. Durch den zeitlichen Verlauf des Spannungsrückgangs kann die Induktivität gemessen werden. Dazu wird die Spannung $U_L$ mit Hilfe des Komparators 38 mit einer Schwellwertspannung $U_S$ verglichen. Die Ausgangsspannung des Komparators 38 weist dann die in Zeile c dargestellte Form auf. Wie später anhand der Fig. 8 genauer erläutert wird, wird im Mikrocomputer 34 die Impulsbreite $t_L$ ermittelt. Ferner wird nach einer vorgegebenen Zeit, in welcher die Spannung $U_L$ mit Sicherheit auf den durch das Verhältnis der Widerstandswerte $R_S$ und $R_L$ abgeklungen ist, der Spannungswert $U_R$ ($\triangleq U_\delta$) in den Mikrocomputer 34 eingelesen und zur Temperaturkompensation verwendet, was im Zusammenhang mit Fig. 9 näher erläutert ist.

Die Zeit $t_L$ wird mit einer in Fig. 8b dargestellten Interrupt-Routine gemessen. Zuvor wird jedoch durch eine Initialisierung 51 (Fig. 8a) eine steigende Flanke am INTP-Eingang als Interrupt-Bedingung festgelegt. Nach dem Auftreten eines durch eine steigende Flanke ausgelösten Interrupts 52 (Fig. 8b) wird zunächst bei 83 der aktuelle Zählerstand des internen Echtzeitzählers gesichert. Auf den Programmteil 53 folgt eine Verzweigung 54 in Abhängigkeit davon, ob eine steigende oder eine fallende Flanke als Interrupt-Bedingung festgelegt wurde.

Bei einem durch eine steigende Flanke ausgelösten Interrupt wird bei 55 ein Verzögerungszeitzähler (Delay-timer) gestartet. Bei 56 wird der gesicherte Wert des Echtzeitzählers in ein Register B eingeschrieben, worauf bei 57 als Interrupt-Bedingung eine fallende Flanke am INTP-Eingang festgelegt wird. Danach wird bei 58 die Interrupt-Routine beendet. Nach der Zeit $t_L$ tritt eine fallende Flanke am INTP-Eingang auf, so daß wiederum ein Interrupt ausgelöst wird. Dieses Mal verzweigt sich jedoch das Programm gemäß Fig. 8b bei 54 in Richtung auf den Programmschritt 59, mit dem die bei $t_L$ durch Subtraktion des Wertes B vom gesicherten Wert des Echtzeitzählers ermittelt wird. Im Anschluß daran wird bei 60 als Interrupt-Bedingung wieder eine steigende Flanke festgelegt. Daraufhin verzweigt sich das Programm.

Fig. 9 zeigt ein Programm, das mit dem Ablauf des Verzögerungszeitzählers bei 61 beginnt. Danach wird bei 62 der Analog/Digital-Wandler ausgelesen ($U_R$). Bei 63 werden Zeiger (Pointer) für eine Korrekturdatei generiert, wobei die Spannung $U_R$ ($\triangleq U_\delta$) dem höherwertigen Byte und die Zeit $t_L$ dem niederwertigen Byte einer Zwei-Byte-Adresse zugeordnet werden. Mit dieser Adresse wird bei 64 der korrigierte Wert $t_{Lk}$ ausgelesen und bei 65 der Verzögerungszeitzähler zugesetzt. Bei 66 ist das Programm zur Temperaturkompensation beendet.

Fig. 10 zeigt den Aufbau der Korrekturdatei. Durch die Adressen von insgesamt 16 Binärstellen ist zur Speicherung der in Fig. 10 dargestellten Korrekturdatei eine relativ große Speicherkapazität erforderlich, die jedoch mit modernen Bauelementen preiswert verwirklicht werden kann. Zur Verminderung der erforderlichen Speicherkapazität kann jedoch in denjenigen Fällen, in denen die korrigierten Werte relativ wenig schwanken, eine Quantisierung beispielsweise der Spannung $U_R$ dadurch vorgenommen werden, daß nur höherwertige Binärstellen ausgewertet werden.

Für geringere Genauigkeitsanforderungen kann eine weitgehende Temperaturkompensation auch durch einfache Bewertung von $t_L$ mit einem durch $U_R$ bestimmten Faktor erreicht werden.

**Patentansprüche**

1. Verfahren zur Messung der Induktivität einer Spule (4), vorzugsweise eines Sensors, bei welchem die Induktivität von einem zu messenden Weg abhängt, wobei die Spule (4) pulsierend mit einer Spannung (U) beaufschlagt wird, der Spannungsabfall an einem Meßwiderstand (8) mit einer Vergleichsspannung verglichen wird, wobei der Spannungsabfall am Beginn der Messung die Vergleichsspannung überschreitet und am Ende der Messung die Vergleichsspannung unterschreitet, und ein Ausgangssignal einen ersten von zwei möglichen Spannungspegeln einnimmt, wenn der Spannungsabfall kleiner als die Vergleichsspannung ist, dadurch gekennzeichnet, daß die Spule (4) über den Meßwiderstand (8) mit der pulsierenden Spannung beaufschlagt wird, wobei die pulsierende Spannung direkt an den Meßwiderstand (8) angelegt wird und das Ausgangssignal beim Anlegen der Spannung an den Meßwiderstand (8) nach einer ersten Zeitverzögerung ($t_2$) einen zweiten von zwei möglichen Spannungspegeln einnimmt und der erste der beiden Spannungspegel nach einer weiteren Verzögerungszeit ($t_3$) eingenommen wird, wobei beide Verzögerungszeiten ($t_2$, $t_3$) im wesentlichen identisch sind.

2. Verfahren nach Anspruch 1, dadurch gekennzeichnet, daß die Spule (4) während einer Dauer ($T_P$) mit der Spannung (u) beaufschlagt ist, welche größer als die Zeit ist, die zwischen dem Beginn der Beaufschlagung und dem Zeitpunkt ist, zu dem der Spannungsabfall die Vergleichsspannung überschreitet.

3. Verfahren nach Anspruch 2 zur Messung der Induktivitäten mehrerer Spulen (4, 4', 4''), dadurch gekennzeichnet, daß die Beaufschlagung der Spulen (4, 4', 4'') mit der Spannung (u) über je einen Meßwiderstand (8) gleichzeitig erfolgt und daß die Ausgangssignale getrennt einer Auswerteeinrichtung (21) zugeführt werden.

4. Verfahren nach Anspruch 2 zur Messung der Induktivitäten mehrerer Spulen (4, 4', 4"), dadurch gekennzeichnet, daß die Beaufschlagung der Spulen (4, 4', 4") mit der Spannung (u) zeitlich versetzt erfolgt und daß die Ausgangssignale nach einer logischen Verknüpfung gemeinsam einer Auswerteeinrichtung (21) zugeführt werden.

5. Verfahren nach einem der vorhergehenden Ansprüche, dadurch gekennzeichnet, daß die an der Spule (u) im eingeschwungenen Zustand abfallende Spannung ($U_R$) gemessen und zur Korrektur einer vom Ausgangssignal abgeleiteten Größe verwendet wird.

6. Schaltungsanordnung zur Durchführung des Verfahrens nach Anspruch 1, bestehend aus einer Reihenschaltung aus einem Meßwiderstand (8) und einer Spule (4), die über einen steuerbaren Schalter (7) mit einer Spannung beaufschlagbar ist, wobei an die gleiche Spannung ein Spannungsteiler (10, 11) angeschlossen ist und der Ausgang (13) des Spannungsteilers (10, 11) und der Verbindungspunkt (12) zwischen dem Meßwiderstand (8) und der Spule (4) mit Eingängen eines Komparators (14) verbunden sind, dadurch gekennzeichnet, daß der Ausgang des Schalters (7) mit dem Eingang des Meßwiderstandes (8) direkt verbunden ist, daß einem Eingang des Schalters (7) ein rechteckförmiges Taktsignal zugeführt ist und dem weiteren Eingang des Schalters (7) die Spannung zugeführt ist, so daß der Meßwiderstand (8) mit der Spannung als pulsierender Spannung beaufschlagt wird.

7. Schaltungsanordnung nach Anspruch 6, dadurch gekennzeichnet, daß der Spannungsteiler (10, 11) an die Spannung über einen mit dem steuerbaren Schalter (7) gleichartigen weiteren Schalter (9) angeschlossen ist.

8. Schaltungsanordnung zur Durchführung des Verfahrens nach Anspruch 5, bestehend aus einer Reihenschaltung aus einem Meßwiderstand (37) und einer Spule (4), die über einen steuerbaren Schalter (36) mit einer Spannung beaufschlagbar ist, wobei an die gleiche Spannung ein Spannungsteiler (39, 40) angeschlossen ist und der Ausgang des Spannungsteilers (39, 40) und der Verbindungspunkt (32) zwischen dem Meßwiderstand (37) und der Spule (4) mit Eingängen eines Komparators (38) verbunden sind, dadurch gekennzeichnet, daß der Ausgang des steuerbaren Schalters (36) mit dem Eingang des Meßwiderstandes (37) direkt verbunden ist und dem steuerbaren Schalter (36) ein rechteckförmiges Taktsignal zugeführt und dem Eingang des Schalters (36) die Spannung zugeführt ist, so daß der Meßwiderstand (37) mit der Spannung als pulsierender Spannung beaufschlagt wird, und ferner zur Temperaturmessung der Verbindungspunkt (32) zwischen der Spule (4) und dem Meßwiderstand (37) mit einem Analogsignaleingang eines Mikrocomputers (34) verbunden ist und daß der Ausgang des Komparators (38) an einen weiteren Eingang des Mikrocomputers (34) angeschlossen ist.

**Claims**

1. A procedure for measuring the inductance of a coil (4), preferably of a sensor, in which the inductance depends on a distance to be measured, wherein the coil (4) is acted upon pulsatingly by a voltage (U), the voltage drop at a measuring resistor (8) is compared with a comparison voltage, wherein the voltage drop exceeds the comparison voltage at the start of the measurement and falls below the comparison voltage at the end of the measurement, and an output signal assumes a first of two possible voltage levels when the voltage drop is less than the comparison voltage, characterised in that the coil (4) is acted upon by the pulsating voltage via the measuring resistor (8), wherein the pulsating voltage is applied directly to the measuring resistor (8) and on applying the voltage to the measuring resistor (8) the output signal assumes a second of two possible voltage levels after a first time delay ($t_2$), and the first of the two voltage levels is assumed after a further time delay ($t_3$), wherein the two delay periods ($t_2$, $t_3$) are substantially identical.

2. A procedure according to claim 1, characterised in that the coil (4) is acted upon by the voltage (U) for a duration ($T_p$) which is longer than the period which is between the start of the action of the voltage and the time at which the voltage exceeds the comparison voltage.

3. A procedure according to claim 2 for measuring the inductances of a plurality of coils (4, 4', 4"), characterised in that the action of the voltage (U) on the coils (4, 4', 4") is effected simultaneously via a measuring resistor (8) in each case and that the output signals are fed separately to an evaluation device (21).

4. A procedure according to claim 2 for measuring the inductances of a plurality of coils (4, 4', 4"), characterised in that the action of the voltage (U) on the coils (4, 4', 4") is effected displaced in time and that the output signals are fed jointly to an evaluation device (21) after a logic switching operation.

5. A procedure according to any one of the preceding claims, characterised in that the voltage ($U_R$) which is dropping at the coil (4) is measured in its transient state and is used for the correction of a quantity derived from the output signal.

6. A circuit arrangement for carrying out the procedure according to claim 1, consisting of a series connection comprising a measuring resistor (8) and a coil (4) which can be acted upon by a voltage via a controllable switch (7), wherein a voltage divider (10, 11) is connected at the same voltage and the output (13) of the voltage divider (11, 12) and the connection point (12) between the measuring resistor (8) and the coil (4) are connected to inputs of a comparator (14), characterised in that the output of the switch (7) is directly connected to the input of the measuring resistor (8), that a rectangular timing signal is fed to one input of the switch (7) and the voltage is fed to the other input of the switch (7), so that the measuring resistor is acted upon by the voltage as a pulsating voltage.

7. A circuit arrangement according to claim 6, characterised in that the voltage divider (10, 11) is connected to the voltage via a further switch (9) of the same type as the controllable switch (7).

8. A circuit arrangement for carrying out the procedure according to claim 5, consisting of a series connection comprising a measuring resistor (37) and a coil (4) which can be acted upon by a voltage via a controllable switch (36), wherein a voltage divider (39, 40) is connected at the same voltage and the output of the voltage divider (39, 40) and the connection point (32) between the measuring resistor (37) and the coil (4) are connected to inputs of a comparator (38), characterised in that the output of the switch (36) is directly connected to the input of the measuring resistor (37) and a rectangular timing signal is fed to the controllable switch (36) and the voltage is fed to the input of the switch (36), so that the measuring resistor (37) is acted upon by the voltage as a pulsating voltage, and in addition, for measuring the temperature, the connection point (32) between the coil (4) and the measuring resistor (37) is connected to an analogue signal input of a microcomputer (34), and that the output of the comparator (38) is connected to a further input of the microcomputer (34).

**Revendications**

1. Procédé de mesure de l'inductance d'une bobine (4), de préférence d'un capteur, dans le cas duquel l'inductance dépend d'une course à mesurer, dans lequel on met de façon pulsatoire la bobine (4) sous une tension (U), on compare la chute de tension à une résistance de mesure (8) avec une tension de comparaison, la chute de tension dépassant, par valeur croissante, la tension de comparaison au début de la mesure et dépassant, par valeur décroissante, la tension de comparaison à la fin de la mesure, et dans le cas duquel un signal de sortie prend un premier de deux niveaux de tension possibles, lorsque la chute de tension est inférieure à la tension de comparaison, caractérisé par le fait que l'on amène une tension pulsatoire dans la bobine (4) par l'intermédiaire de la résistance de mesure (8), la tension pulsatoire étant directement appliquée à la résistance de mesure (8), et que, lors de l'application de la tension à la résistance de mesure (8), après un premier temps de retard ($t_2$), le signal de sortie prend un second de deux niveaux de tension possibles et qu'après un autre temps de retard ($t_3$), ce soit le premier des deux niveaux de tension qui soit pris, les deux temps de retard ($t_2$, $t_3$) étant essentiellement identiques.

2. Procédé de la revendication 1, caractérisé par le fait que l'on amène la tension (U) dans la bobine (4) pendant une durée ($T_p$) qui est supérieure au temps qui s'écoule entre le début de la mise sous tension et l'instant où la chute de tension dépasse, par valeur positive, la tension de comparaison.

3. Procédé de la revendication 2 pour mesurer les inductances de plusieurs bobines (4, 4', 4") caractérisé par le fait que la mise sous la tension (U) des bobines (4, 4', 4") se fait simultanément par l'intermédiaire de, pour chacune, une résistance de mesure (8) et que les signaux de sortie sont envoyés séparément à un dispositif de traitement (21).

4. Procédé de la revendication 2 pour mesurer les inductances de plusieurs bobines (4, 4', 4") caractérisé par le fait que la mise sous la tension (U) des bobines (4, 4', 4") se fait avec un décalage dans le temps et qu'après une liaison logique les signaux de sortie sont envoyés ensemble à un circuit de traitement (21).

5. Procédé selon l'une des revendications précédentes, caractérisé par le fait que l'on mesure la tension ($U_R$) décroissante en régime transitoire et qu'on l'emploie pour corriger une valeur déduite du signal de sortie.

6. Disposition de circuit pour la mise en oeuvre du procédé selon la revendication 1, constituée d'un circuit de série composé d'une résistance de mesure (8) et d'une bobine (4) que l'on peut mettre sous tension au moyen d'un interrupteur (7) que l'on peut commander, un diviseur de tension (10, 11) étant relié à la même tension et la sortie (13) du diviseur de tension (10, 11) et le point de liaison (12) entre la résistance de mesure (8) et la bobine (4) étant relié aux entrées d'un comparateur (14), caractérisée par le fait que la sortie de l'interrupteur (7) est directement reliée à l'entrée de la résistance de mesure (8), qu'un signal d'horloge de forme rectangulaire arrive à l'entrée de l'interrupteur (7) et que la tension arrive à l'autre entrée d'interrupteur (7), de sorte que c'est sous forme d'une tension pulsatoire que la tension est mise aux bornes de la résistance de mesure (8).

7. Disposition de circuit selon la revendication 6, caractérisée par le fait que le diviseur de tension (10, 11) est relié à la tension par l'intermédiaire d'un autre interrupteur (9) de même type que l'interrupteur (7) que l'on peut commander.

8. Disposition de circuit pour la mise en oeuvre du procédé selon la revendication 5, constituée d'un circuit de série composé d'une résistance de mesure (37) et d'une bobine (4) que l'on peut mettre sous tension au moyen d'un interrupteur (36) que l'on peut commander, un diviseur de tension (39, 40) étant relié à la même tension et la sortie du diviseur de tension (39,40) et le point de liaison (32) entre la résistance de mesure (37) et la bobine (4) étant reliés aux entrées d'un comparateur (38), caractérisée par le fait que la sortie de l'interrupteur (36) que l'on peut commander est directement reliée à l'entrée de la résistance de mesure (37) et qu'un signal d'horloge de forme rectangulaire est envoyé à l'interrupteur (36) que l'on peut commander et que la tension est amenée à l'entrée de l'interrupteur (36) de sorte que c'est sous forme d'une tension pulsatoire que la tension est mise aux bornes de la résistance de mesure (37) et qu'en outre pour la mesure de la température le point de liaison (32) entre la bobine (4) et la résistance de mesure (37) est relié à une entrée de signaux analogiques d'un micro-ordinateur (34) et que la sortie du comparateur (38) est reliée à une autre entrée du micro-ordinateur (34).

Fig. 1

Fig. 2

Fig. 3

Fig. 4

Fig. 5

Fig. 6

Fig. 7

```
┌─────────────────────────────┐ 51
│  Interruptbedingung :       │
│   Steigende  Flanke         │
│   am  INTP-Eingang!         │
└─────────────────────────────┘
```

Fig. 8 a

```
        ( Interrupt! )  52

  ┌─────────────────────────┐ 53
  │   Zählerstand  des       │
  │  Realtime - Counters     │
  │   sichern.  (Capture)    │
  └─────────────────────────┘

              ◇ 54
          Inter-
      ruptbedingung:         ja
      steigende  Flanke  ─────────────┐
            ?
           nein

  ┌──────────────────────┐ 59    ┌──────────────────────────┐ 55
  │ tL = Capturewert - B │       │   Delaytimer  starten    │
  └──────────────────────┘       └──────────────────────────┘

                                 ┌──────────────────────────┐ 56
                                 │     B = Capturewert      │
                                 └──────────────────────────┘

  ┌──────────────────────┐ 60    ┌──────────────────────────┐ 57
  │  Interruptbedingung : │       │   Interruptbedingung :   │
  │   Steigende  Flanke   │       │    Fallende  Flanke      │
  │  am INTP-Eingang!     │       │   am  INTP-Eingang!      │
  └──────────────────────┘       └──────────────────────────┘

        ( Ende )  58
```

Fig. 8 b

```
                    ┌─────────────────────────────┐
                   ( Delaytimer abgelaufen !      )  61
                    └─────────────────────────────┘
                                  │
                    ┌─────────────────────────────┐
                    │  AD-Wandler auslesen        │  62
                    │        (U_ϑ)                │
                    └─────────────────────────────┘
                                  │
                    ┌─────────────────────────────┐
                    │  Pointer für Korrektur-     │  63
                    │  daten generieren           │
                    │  z.B. U_ϑ = Highbyte        │
                    │      t_L  = Lowbyte         │
                    └─────────────────────────────┘
                                  │
                    ┌─────────────────────────────┐
                    │  Temp. korregierten         │  64
                    │  t_{LK}-Wert aus Datei      │
                    │       holen                 │
                    └─────────────────────────────┘
                                  │
                    ┌─────────────────────────────┐
                    │  Delaytimer  reset          │  65
                    └─────────────────────────────┘
                                  │
                             ┌─────────┐
                            ( Ende     )  66
                             └─────────┘
```

Fig. 9

Fig. 10